# EUROPÄISCHE PATENTSCHRIFT

(11) **EP 4 019 983 B1**
(45) Veröffentlichungstag und Bekanntmachung des Hinweises auf die Patenterteilung: **28.01.2026**
(21) Anmeldenummer: 21214683.1
(22) Anmeldetag: 15.12.2021
(51) Int. Cl.: G01R 11/04, G01R 22/06, G01R 11/24, G01R 35/00, G01R 3/00

(54) **GEHÄUSE FÜR EINEN ELEKTRIZITÄTSZÄHLER**
CASING FOR AN ELECTRICITY METER
BOÎTIER POUR UN COMPTEUR D'ÉLECTRICITÉ

(30) Priorität: 22.12.2020 DE 102020134574
(43) Veröffentlichungstag der Anmeldung: 29.06.2022
(73) Patentinhaber: EMH metering GmbH & Co. KG, 19258 Gallin (DE)
(72) Erfinder: Horn, Wolfgang, 39326 Hohenwarsleben (DE)
(74) Vertreter: Hauck Patent- und Rechtsanwälte PartmbB

(56) Entgegenhaltungen:
- EP-B1- 1 659 411
- DE-C1- 19 712 239
- GB-A- 2 431 244

## Beschreibung

Die Erfindung betrifft ein Gehäuse für einen Elektrizitätszähler mit einem Gehäuseunterteil, das ein erstes Rastelement aufweist, und einem Gehäuseoberteil, das ein zweites Rastelement aufweist. Um das Gehäuse zu schließen, können Gehäuseoberteil und Gehäuseunterteil entlang einer Schließrichtung zusammengeführt werden, sodass die beiden Rastelemente miteinander verrastet sind.

Ein derartiges Gehäuse ist aus der Druckschrift EP 1 657 554 B1 bekannt geworden. Das bekannte Gehäuse zeichnet sich dadurch aus, dass die im Inneren des Gehäuses angeordneten Komponenten des Elektrizitätszählers vor Manipulation und versehentlicher Berührung gleichermaßen gut geschützt sind. Die Montage des Elektrizitätszählers endet mit dem Schließen des Gehäuses durch einfaches Zusammenstecken von Gehäuseunterteil und Gehäuseoberteil. Durch die automatische, sichere Verrastung der beiden Rastelemente ist ein nachträgliches Öffnen des Gehäuses nicht möglich, jedenfalls nicht ohne das Gehäuse zu beschädigen oder sonstige Spuren zu hinterlassen.

Aus der Druckschrift DE 197 12 239 C1 ist ein Gehäuse für einen Elektrizitätszähler mit den Merkmalen des Oberbegriffs des Anspruchs 1 bekannt geworden. Zusätzlich weist das Gehäuseoberteil Durchgangsöffnungen auf, in denen jeweils ein am Gehäuseunterteil befestigter Plombierungsträger angeordnet ist, sodass an der Vorderseite eine Plombe angebracht werden kann.

Davon ausgehend ist es die Aufgabe der Erfindung, ein Gehäuse für einen Elektrizitätszähler und ein Verfahren zur Montage eines Elektrizitätszählers zur Verfügung zu stellen, mit denen sich Ablauf und Ergebnis der Montage nochmals verbessern.

Diese Aufgabe wird gelöst durch das Gehäuse für einen Elektrizitätszähler mit den Merkmalen des Anspruchs 1 sowie durch das Verfahren zur Montage eines Elektrizitätszählers mit den Merkmalen des Anspruchs 10. Vorteilhafte Ausgestaltungen sind in den sich jeweils anschließenden Unteransprüchen angegeben.

Das Gehäuse nach Anspruch 1 ist für einen Elektrizitätszähler bestimmt. Es hat ein Gehäuseunterteil, das ein erstes Rastelement aufweist, und ein Gehäuseoberteil, das ein zweites Rastelement aufweist, wobei das Gehäuse dazu ausgebildet ist, durch Zusammenführen von Gehäuseoberteil und Gehäuseunterteil entlang einer Schließrichtung geschlossen zu werden, wobei das erste Rastelement und das zweite Rastelement bei geschlossenem Gehäuse miteinander verrastet sind, und wobei das Gehäuseunterteil eine Durchgangsöffnung und das Gehäuseoberteil einen Zapfen aufweist, der bei geschlossenem Gehäuse in der Durchgangsöffnung angeordnet ist.

Wenn das erste Rastelement und das zweite Rastelement miteinander verrastet sind, ist das Gehäuse geschlossen und das Gehäuseoberteil kann nicht von dem Gehäuseunterteil entfernt werden, ohne die Gehäuseteile zu beschädigen oder die Rastverbindung zu lösen.

Insbesondere kann das Gehäuseunterteil mehrere erste Rastelemente aufweisen und das Gehäuseoberteil kann mehrere zweite Rastelemente aufweisen, wobei jedes Paar von Rastelementen eine Rastverbindung bildet. Zum Beispiel können zwei Paare mit jeweils einem ersten und einem zweiten Rastelement auf einander gegenüberliegenden Seiten des Gehäuseunterteils bzw. des Gehäuseoberteils angeordnet sein.

In dem Gehäuse können insbesondere die Komponenten eines elektronischen Elektrizitätszählers angeordnet sein, zum Beispiel eine Leiterplatte mit mindestens einem integrierten Schaltkreis und eine elektronische Anzeige. Das geschlossene Gehäuse kann etwa quaderförmig ausgebildet sein. Das Gehäuseunterteil weist eine Rückwand auf, die beim Einbau des Elektrizitätszählers einer Wand, beispielsweise in einem Zählerschrank, zugewandt ist. An dem Gehäuseunterteil können Steckkontakte und Laschen zur Montage an einem Stecksockel ausgebildet sein. Alternativ kann der Elektrizitätszähler Befestigungsöffnungen zur Schraubbefestigung an einer Wand sowie Anschlussklemmen zum Anschließen an ein elektrisches Versorgungsnetz aufweisen, insbesondere an dem Gehäuseunterteil. Eine Leiterplatte mit mindestens einem integrierten Schaltkreis kann ebenfalls an dem Gehäuseunterteil befestigt sein. Das Gehäuseoberteil weist eine Vorderseite auf, die bei an einer Wand befestigten Anordnung des Elektrizitätszählers einer Bedienperson zugewandt ist. Die Vorderseite kann mit einer Beschriftung und/oder mit einem Typenschild versehen sein. Außerdem kann an der Vorderseite eine elektronische Anzeige angeordnet sein. Das Gehäuseunterteil und das Gehäuseoberteil können jeweils kastenförmig ausgebildet sein, es ist jedoch auch möglich, dass ein im Wesentlichen senkrecht zu der Rückwand ausgerichteter Rahmen nur oder fast nur an einem der beiden Gehäuseteile ausgebildet ist, während das andere Gehäuseteil im Wesentlichen auf eine Rückwand bzw. auf eine Vorderseite reduziert sein kann.

Zum Schließen des Gehäuses werden Gehäuseoberteil und Gehäuseunterteil entlang einer Schließrichtung zusammengeführt. Dann verrasten die beiden Rastelemente miteinander und halten das Gehäuseunterteil und das Gehäuseoberteil in der geschlossenen Stellung. Beispielsweise kann das erste Rastelement eine Lasche mit einer Öffnung und das zweite Rastelement kann eine Rastnase sein, oder umgekehrt. Insbesondere können die beiden miteinander zusammenwirkenden Rastelemente so ausgebildet sein, wie in der eingangs genannten Druckschrift EP 1 657 554 B1 im Einzelnen beschrieben.

Eine Besonderheit der Erfindung besteht darin, dass das Gehäuseunterteil eine Durchgangsöffnung und das Gehäuseoberteil einen Zapfen aufweist, der bei geschlossenem Gehäuse in der Durchgangsöffnung angeordnet ist. Das bedeutet, dass im geschlossenen Zustand die Durchgangsöffnung von dem Zapfen hinreichend verschlossen ist, um das Innere des Gehäuses vor unbefugtem Zugriff zu schützen. Insbesondere kann der Zapfen in die Durchgangsöffnung eingreifen und diese vollständig oder fast vollständig verschließen. Dieses Zusammenwirken von Durchgangsöffnung und Zapfen ergibt sich beim Zusammenführen der beiden Gehäuseteile aufgrund der korrespondierenden Anordnung von Durchgangsöffnung und Zapfen automatisch. Insbesondere können die Durchgangsöffnung und der Zapfen jeweils eine Längsrichtung aufweisen, die mit der Schließrichtung zusammenfällt. Dadurch wird der Zapfen beim Zusammenführen der beiden Gehäuseteile in die Durchgangsöffnung hineingesteckt. Die Querschnitte von Durchgangsöffnung und Zapfen können aufeinander abgestimmt sein, wobei sie eine beliebige Geometrie aufweisen können, beispielsweise etwa kreisförmig oder halbkreisförmig oder auch quadratisch oder rechteckig. Beispielsweise können Durchgangsöffnung und Zapfen einen Durchmesser im Bereich von 1 mm bis 8 mm aufweisen. Der Zapfen kann in einem seitlichen Abstand von dem zweiten Rastelement an dem Gehäuseoberteil ausgebildet sein. Ebenfalls denkbar ist, dass der Zapfen und das zweite Rastelement ein integriertes Bauteil bilden. Beispielsweise können beide von unterschiedlichen Längsabschnitten eines von der Innenseite des Gehäuseoberteils vorstehenden Arms gebildet sein. Bevorzugt befindet sich der Zapfen jedoch in einem seitlichen Abstand (d.h. gemessen senkrecht zu der Schließrichtung) von dem zweiten Rastelement, sodass die Verrastung der beiden Rastelemente im Wesentlichen unbeeinflusst von dem Eingriff des Zapfens in die Durchgangsöffnung erfolgen kann.

Die erfindungsgemäße Anordnung einer Durchgangsöffnung und eines Zapfens an den beiden Gehäuseteilen können die Montage des Elektrizitätszählers in zweierlei Hinsicht entscheidend verbessern. Zum einen ist der Zapfen von der Unterseite des Gehäuses aus durch die Durchgangsöffnung hindurch zugänglich. Er bietet daher im geschlossenen Zustand des Gehäuses eine einfache Möglichkeit, von der Unterseite des Gehäuses aus eine Kraft auf das Gehäuseoberteil auszuüben. Anhand dieser Kraft kann insbesondere verifiziert werden, ob die beiden Rastelemente in der vorgesehenen Weise miteinander verrastet sind. Hierzu genügt es, bei geschlossenem Gehäuse das Gehäuseunterteil zu fixieren und mit einem Anschlagelement eine Kraft auf den Zapfen auszuüben, insbesondere mit einem stiftartigen Werkzeug, das unter Ausführung einer Kraft-Weg-Messung von der Seite des Gehäuseunterteils aus gegen den Zapfen gefahren wird. Auf diese Weise lässt sich überprüfen, ob das Gehäuse ordnungsgemäß geschlossen ist, was vorzugsweise ganz am Ende des Montageablaufs sinnvoll ist.

Zum anderen kann das Gehäuseoberteil bei vormontiertem Gehäuse mithilfe eines durch die Durchgangsöffnung auf den Zapfen einwirkenden Werkzeugs in einer gewünschten Stellung gehalten werden. Dadurch kann insbesondere nach Abschluss einer individuellen Konfiguration des Elektrizitätszählers eine Beschriftung an der Vorderseite angebracht werden, bevor das Gehäuse geschlossen wird. Es können also in einem ersten Schritt die für den individuellen Elektrizitätszähler vorgesehenen Hardware- und Software-Komponenten im Inneren des Gehäuses angeordnet werden. Dann kann das Gehäuseoberteil auf das Gehäuseunterteil aufgesetzt, jedoch noch nicht damit verrastet werden. Das Gehäuseoberteil kann sich dann insbesondere in einem Vormontageabstand von dem Gehäuseunterteil befinden. In dieser Stellung sind die individualisierten elektronischen Komponenten bereits in dem Gehäuse aufgenommen. Es kann dann die gewünschte Beschriftung, die Informationen über die individuelle Konfiguration des Elektrizitätszählers enthält, an dem Gehäuseoberteil angebracht werden, wobei das Gehäuseoberteil mithilfe eines geeigneten Werkzeugs, das durch die Durchgangsöffnung hindurch an dem Zapfen angreift, in die optimale Beschriftungsposition gebracht bzw. in dieser gehalten werden kann. Dies ist insbesondere von Bedeutung bei einer Laserbeschriftung, bei der sich die zu beschriftende Fläche in einer definierten Ebene des Beschriftungsgeräts befinden muss. Beispielsweise kann das Gehäuseoberteil gegen entsprechende Anschläge eines Beschriftungsgeräts gepresst werden, indem eine Kraft auf den Zapfen ausgeübt wird. Anschließend kann gegebenenfalls die Qualität der Beschriftung überprüft werden, bevor das Gehäuse durch vollständiges Zusammenführen von Gehäuseoberteil und Gehäuseunterteil geschlossen wird.

In einer Ausgestaltung ist bei geschlossenem Gehäuse ein Längsabschnitt der Durchgangsöffnung frei von dem Zapfen und von einer Außenseite des Gehäuseunterteils aus zugänglich. In diesen Längsabschnitt der Durchgangsöffnung kann ein geeignetes Werkzeug eingesetzt werden, insbesondere für die geschilderte Überprüfung der Verrastung. Dabei verhindert der einfach zugängliche und freibleibende Längsabschnitt der Durchgangsöffnung, dass das Werkzeug seitlich abrutscht.

In einer Ausgestaltung weist das Gehäuse Führungsmittel auf, die während des Zusammenführens von Gehäuseoberteil und Gehäuseunterteil eine Führung des Gehäuseoberteils relativ zum Gehäuseunterteil bewirken, sodass die Bewegung des Gehäuseoberteils relativ zu dem Gehäuseunterteil spätestens beim Erreichen eines Vormontageabstands im Wesentlichen auf die Schließrichtung beschränkt ist, wobei bei Erreichen des Vormontageabstands das erste Rastelement und das zweite Rastelement noch nicht miteinander verrastet sind. Diese Führung vereinfacht das ordnungsgemäße Zusammenführen der beiden Gehäuseteile. Die Führung erleichtert gleichermaßen das Zusammenführen der beiden Gehäuseteile bis zum Erreichen des Vormontageabstands, von dem ausgehend das Gehäuse jederzeit wieder geöffnet werden kann, und das Zusammenführen ausgehend von dem Vormontageabstand hin zu der geschlossenen Stellung des Gehäuses.

In einer Ausgestaltung sind die Führungsmittel von dem Zapfen und der Durchgangsöffnung gebildet. Hierzu sind der Zapfen und die Durchgangsöffnung so angeordnet und bemessen, dass der Zapfen bereits vor dem Erreichen des Vormontageabstands in die Durchgangsöffnung hineinragt. Spätestens wenn der Vormontageabstand erreicht ist, ist die mögliche Bewegungsrichtung des Gehäuseoberteils relativ zu dem Gehäuseunterteil durch die Führung des Zapfens in der Durchgangsöffnung auf die Schließrichtung beschränkt.

In einer Ausgestaltung ist der Zapfen bei geschlossenem Gehäuse über eine vorgegebene Länge in der Durchgangsöffnung angeordnet, wobei die vorgegebene Länge größer ist als der Vormontageabstand. In diesem Fall greift der Zapfen schon vor dem Erreichen des Vormontageabstands in die Durchgangsöffnung ein und bewirkt die gewünschte Führung. Insbesondere wird verhindert, dass bei vormontiertem Gehäuse (d.h., wenn sich die beiden Gehäuseteile in dem Vormontageabstand voneinander befinden) das Gehäuseoberteil seitlich zu dem Gehäuseunterteil verschoben wird. Dadurch ist das Gehäuseoberteil bereits soweit in seiner vorgesehenen Position fixiert, dass die im Inneren des Gehäuses aufgenommenen Komponenten geschützt sind und ein unabsichtliches Verrutschen des Gehäuseoberteils vermieden wird. Dennoch kann das Gehäuseoberteil gegebenenfalls einfach wieder von dem Gehäuseunterteil entfernt werden, insbesondere in einer Öffnungsrichtung, die der Schließrichtung entgegengesetzt gerichtet ist.

In einer Ausgestaltung sind an dem Gehäuseoberteil und/oder an dem Gehäuseunterteil Blockiermittel angeordnet, die ausgehend von dem Vormontageabstand ein weiteres Zusammenführen des Gehäuseoberteils und des Gehäuseunterteils blockieren. Insbesondere können die Blockiermittel so ausgebildet sein, dass ein weiteres Zusammenführen der beiden Gehäuseteile nur unter Überwindung eines Widerstands oder nach dem Entfernen oder Verschieben der Blockiermittel möglich ist. Ein unbeabsichtigtes, vollständiges Schließen des Gehäuses wird dadurch wirksam verhindert.

In einer Ausgestaltung weisen die Blockiermittel eine in der Durchgangsöffnung angeordnete Barriere auf bzw. sind von dieser gebildet. Die Barriere kann die Durchgangsöffnung in einem Längsabschnitt ganz oder teilweise verschließen oder verkleinern. Beispielsweise kann es sich um eine in der Durchgangsöffnung angeordnete Folie handeln. Alternativ kann die Durchgangsöffnung eine Querschnittsveränderung, beispielsweise eine Unrundheit, aufweisen. Nur unter Überwindung eines Widerstands kann die Barriere beim Zusammenführen der beiden Gehäuseteile überwunden werden, beispielsweise indem die Folie durchstochen oder eine Querschnittsveränderung der Durchgangsöffnung soweit verformt wird, dass der Zapfen in der Durchgangsöffnung angeordnet werden kann.

In einer Ausgestaltung weisen die Blockiermittel eine Querschnittsvergrößerung des Zapfens auf bzw. sind von dieser gebildet. Beispielsweise kann an dem Zapfen eine kleine Rippe in Längsrichtung ausgebildet sein, die von dem Zapfen abgeschert wird, wenn die beiden Gehäuseteile mit hinreichender Kraft zusammengeführt werden.

In einer Ausgestaltung weist das Gehäuseunterteil mehrere erste Rastelemente und eine entsprechende Anzahl an Durchgangsöffnungen und das Gehäuseoberteil mehrere zweite Rastelemente und eine entsprechende Anzahl an Zapfen auf, wobei jedes Paar von Rastelementen eine Rastverbindung bildet und bei geschlossenem Gehäuse jeder Rastverbindung eine Durchgangsöffnung mit einem darin angeordneten Zapfen zugeordnet ist. Beispielsweise können zwei, drei oder vier Rastverbindungen und zugehörige Durchgangsöffnung-Zapfen-Kombinationen vorhanden sein. Beispielsweise kann an jeder Ecke des rechteckigen Gehäuses eine Rastverbindung und benachbart dazu eine Durchgangsöffnung mit einem Zapfen vorgesehen sein. Durch eine größere Anzahl von Rastverbindungen wird eine besonders sichere Verrastung der beiden Gehäuseteile erreicht. Durch die Zuordnung einer Durchgangsöffnung mit einem darin angeordneten Zapfen zu jeder Rastverbindung kann bei der geschilderten Überprüfung der Rastverbindung jede einzelne Rastverbindung kontrolliert werden.

Die oben angegebene Aufgabe wird ebenfalls gelöst durch das Verfahren mit den Merkmalen des Anspruchs 10. Das Verfahren dient zur Montage eines Elektrizitätszählers und weist die folgenden Schritte auf:
- Anordnen eines Gehäuseunterteils, das ein erstes Rastelement und eine Durchgangsöffnung aufweist, in einer Montageposition,
- Anordnen eines Gehäuseoberteils, das ein zweites Rastelement und einen Zapfen aufweist, in einem Abstand von dem Gehäuseunterteil,
- Zusammenführen des Gehäuseoberteils und des Gehäuseunterteils in einer Schließrichtung, bis das Gehäuse geschlossen ist, das erste Rastelement und das zweite Rastelement miteinander verrastet sind und der Zapfen in der Durchgangsöffnung angeordnet ist.

Zu den Merkmalen und Vorteilen des Verfahrens wird auf die vorstehenden Erläuterungen des Gehäuses verwiesen. Vor dem Zusammenführen der beiden Gehäuseteile kann der Elektrizitätszähler in der gewünschten Weise konfiguriert werden, indem die jeweiligen Komponenten innerhalb des Gehäuses angeordnet und eine gegebenenfalls individualisierte Software (Firmware) aufgespielt wird.

In der Montageposition kann das Gehäuseunterteil beispielsweise auf einem Montagetisch angeordnet sein, sodass es mit einer Unterseite auf dem Montagetisch liegt. Anschließend, vor dem Anordnen des Gehäuseoberteils, können die gewünschten Komponenten des Elektrizitätszählers auf dem Gehäuseunterteil angeordnet und gegebenenfalls daran befestigt werden. Nachfolgend kann das Gehäuseoberteil aufgesetzt und das Gehäuse durch Zusammenführen der beiden Gehäuseteile in einer Schließrichtung geschlossen werden, sodass der Zapfen in der Durchgangsöffnung angeordnet ist, wie bereits in Verbindung mit dem Gehäuse erläutert.

In einer Ausgestaltung weist das Verfahren den folgenden, weiteren Schritt auf:
- Überprüfen, ob das erste Rastelement und das zweite Rastelement miteinander verrastet sind, indem das Gehäuseunterteil fixiert und ein Anschlagelement eines Montagewerkzeugs unter Ausführung einer Kraft-Weg-Messung gegen den Zapfen bewegt wird.

Um zu überprüfen, ob die beiden Rastelemente in der vorgesehenen Weise miteinander verrastet sind, wird das Gehäuseunterteil fixiert. Dabei kann es sich insbesondere weiterhin in seiner Montageposition befinden. Um es zu fixieren, kann es beispielsweise seitlich oder von unten in dieser Position gehalten werden, wahlweise in Verbindung mit einem Vakuumtisch. Das Anschlagelement des Montagewerkzeugs, insbesondere ein Anschlagstift, wird dann gegen den Zapfen bewegt, wobei es gegebenenfalls in einem freien Längsabschnitt der Durchgangsöffnung angeordnet werden kann, bis es an dem Zapfen anliegt. Beispielsweise kann das Anschlagelement von unten gegen den Zapfen bewegt werden. Die Bewegung kann fortgesetzt werden, bis eine vorgesehene Maximalkraft erreicht ist. Je nach Länge des bis dahin zurückgelegten Weg kann einfach festgestellt werden, ob die beiden Rastelemente miteinander verrastet sind. Dies gilt auch für Gehäuse, die eine größere Anzahl von Rastverbindungen (beispielsweise vier an den Ecken des Gehäuses angeordnete) aufweisen, insbesondere bei Verwendung einer entsprechenden Anzahl von Durchgangsöffnungen mit Zapfen. Es versteht sich, dass mehrere Anschlagelemente gleichzeitig eingesetzt werden können, um gegebenenfalls mehrere oder alle Rastverbindungen gleichzeitig zu überprüfen.

In einer Ausgestaltung des Verfahrens werden vor dem Zusammenführen von Gehäuseoberteil und Gehäuseoberteil die folgenden Schritte ausgeführt:
- das Gehäuseoberteil wird in einem Vormontageabstand von dem Gehäuseunterteil angeordnet, so dass der Zapfen in die Durchgangsöffnung hineinragt, wobei das erste Rastelement und das zweite Rastelement nicht miteinander verrastet sind,
- Positionieren eines Anschlagelements eines Montagewerkzeugs im Bereich der Durchgangsöffnung, so dass das Anschlagelement an dem Zapfen anliegt und sich das Gehäuseoberteil in einer vorgegebenen Beschriftungsposition befindet,
- Ausführen einer Beschriftung des Gehäuseoberteils.

Insbesondere kann es sich bei dem Anschlagelement um einen Anschlagstift handeln. Die Beschriftung kann insbesondere eine Laserbeschriftung sein. Wie üblich können die angegebenen Schritte grundsätzlich in beliebiger Reihenfolge ausgeführt werden. Für die Erfindung von Bedeutung ist lediglich, dass die Beschriftung ausgeführt wird, bevor das Gehäuseoberteil und das Gehäuseunterteil bis zur Schließstellung zusammengeführt werden. Vor diesem endgültigen Zusammenführen und nach dem Ausführen der Beschriftung kann wahlweise in einem weiteren Verfahrensschritt die Qualität der Beschriftung überprüft werden. Ergibt diese Überprüfung einen Mangel, kann das Gehäuseoberteil einfach ausgetauscht werden.

In einer Ausgestaltung ist das Gehäuse nach einem der Ansprüche 1 bis 9 ausgebildet. Unter Verwendung eines entsprechend ausgebildeten Gehäuses können die vorstehend erläuterten Vorteile durch Anpassung der Verfahrensschritte erzielt werden. Nachfolgend wird die Erfindung anhand von in Figuren dargestellten Ausführungsbeispielen näher erläutert. Es zeigen:
- Fig. 1: einen Elektrizitätszähler mit geöffnetem Gehäuse in einer perspektivischen Darstellung,
- Fig. 2: den Elektrizitätszähler aus Fig. 1 mit einem Werkzeug in einer Schnittdarstellung,
- Fig. 3: den Elektrizitätszähler aus Fig. 2 in einer Vormontagestellung in einer Schnittdarstellung,
- Fig. 4: den Elektrizitätszähler aus Fig. 2 in geschlossenem Zustand in einer Schnittdarstellung,
- Fig. 5: einen weiteren Elektrizitätszähler mit geschlossenem Gehäuse in einer Schnittdarstellung entlang einer ersten Schnittebene,
- Fig. 6: den Elektrizitätszähler aus Fig. 5 in einer Schnittdarstellung entlang einer zweiten Schnittebene,
- Fig. 7: den Elektrizitätszähler aus Fig. 5 in einer Schnittdarstellung entlang einer dritten Schnittebene,

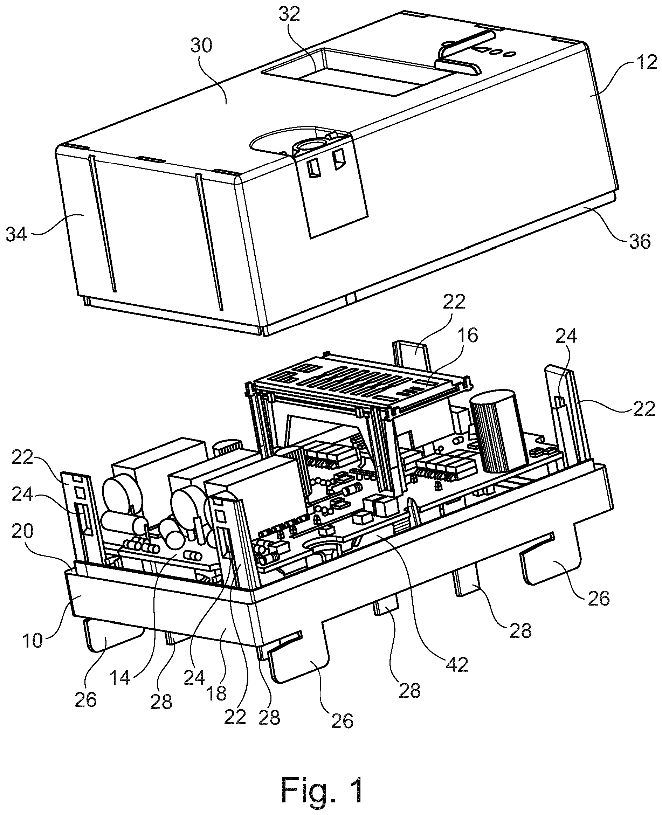

Der Elektrizitätszähler aus Fig. 1 weist ein Gehäuseunterteil 10 und ein entfernt davon angeordnetes Gehäuseoberteil 12 auf. An dem Gehäuseunterteil 10 ist eine Leiterplatte 14 befestigt, die mit zahlreicher elektronischen Bauelementen bestückt ist, unter anderem mit einer elektronischen Anzeige 16. Das Gehäuseunterteil 10 hat eine rechteckige Rückwand 42, die parallel zu der Leiterplatte 14 angeordnet und in der Fig. 1 von der Leiterplatte 14 weitgehend verdeckt ist, sowie einen umlaufenden Rand 18, der etwa senkrecht zu der Rückwand ausgerichtet ist. An der von der Rückwand 42 entfernten Oberseite des Rands 18 gibt es eine umlaufende Nut 20. Außerdem ist an jeder der vier Ecken des Rands 18 ein Arm 22 angeordnet, der von der Oberseite des Rands 18 ausgehend weiter nach oben weist, d.h. in eine von der Rückwand 42 wegführende Richtung. An jedem der Arme 22 ist ein erstes Rastelement in Form einer Rastöffnung 24 ausgebildet.

Der Elektrizitätszähler ist zur Montage in einem Zählerschrank vorgesehen, der mit einem Stecksockel ausgerüstet ist. Hierfür sind an dem Gehäuseunterteil 10 Befestigungslaschen 26 ausgebildet, die in Halteöffnungen des Stecksockels (nicht gezeigt) eingreifen, sowie Steckkontakte 28, die in Steckbuchsen des Stecksockels eingesetzt werden, um eine elektrische Verbindung zu einem elektrischen Versorgungsnetz herzustellen.

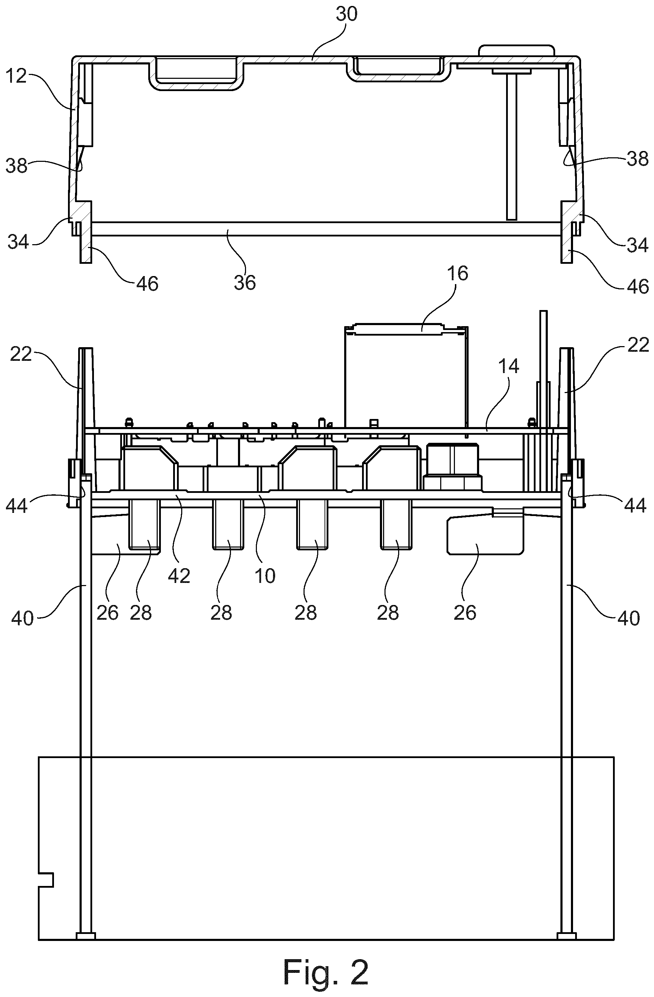

Das Gehäuseoberteil 12 hat eine Vorderseite 30, die bei montiertem Elektrizitätszähler einer Bedienperson zugewandt ist. In der Vorderseite 30 befindet sich ein Fenster 32, hinter dem bei geschlossenem Gehäuse die elektronische Anzeige angeordnet ist. Das Gehäuseoberteil 12 hat ebenfalls einen umlaufenden Rand 34, der bei geschlossenem Gehäuse gemeinsam mit dem Rand 18 des Gehäuseunterteils 10 die vier Seitenwände des insgesamt kastenförmigen Gehäuses bildet. Am unteren, von der Vorderseite 30 entfernten Ende des Rands 34 weist der Rand 34 einen Steg 36 auf, der bei geschlossenem Gehäuse in die Nut 20 eingreift. An der Innenseite des Rands 34 des Gehäuseoberteils 12 befinden sich vier zweite Rastelemente in Form von Rastnasen 38 (in Fig. 1 nicht erkennbar, siehe z.B. Fig. 2), die korrespondierend zu den Rastöffnungen 24 angeordnet sind und bei geschlossenem Gehäuse in diese eingreifen.

Fig. 2 zeigt eine Schnittdarstellung, in der oben das Gehäuseoberteil 12, in der Mitte das Gehäuseunterteil 10 mit Leiterplatte 14 und unten ein Montagewerkzeug mit vier Anschlagstiften 40, von denen zwei sichtbar sind, gezeigt ist. In der gewählten Schnittebene erkennt man benachbart zu den beiden Armen 22 jeweils eine Durchgangsöffnung 44 in der Rückwand 42 des Gehäuseunterteils 10. Insgesamt gibt es vier dieser Durchgangsöffnungen 44. Sie verlaufen jeweils senkrecht zur der Rückwand 42, d.h. in einer Schließrichtung des Gehäuses, entlang der das Gehäuseunterteil 10 und das Gehäuseoberteil 12 zusammengeführt werden, um das Gehäuse zu schließen. In jeder der Durchgangsöffnungen 44 befindet sich einer der Anschlagstifte 40 des Montagewerkzeugs.

Am Gehäuseoberteil 12 sind vier Zapfen 46 angeordnet, von denen in der Fig. 2 zwei sichtbar sind. Sie befinden sich jeweils an einer Unterseite des Rands 34 und weisen über die Ebene, in der der Steg 36 angeordnet ist, hinaus in der Schließrichtung nach unten. Jeder Zapfen 46 ist benachbart zu einer der Rastnasen 38, in einem seitlichen Abstand davon, angeordnet.

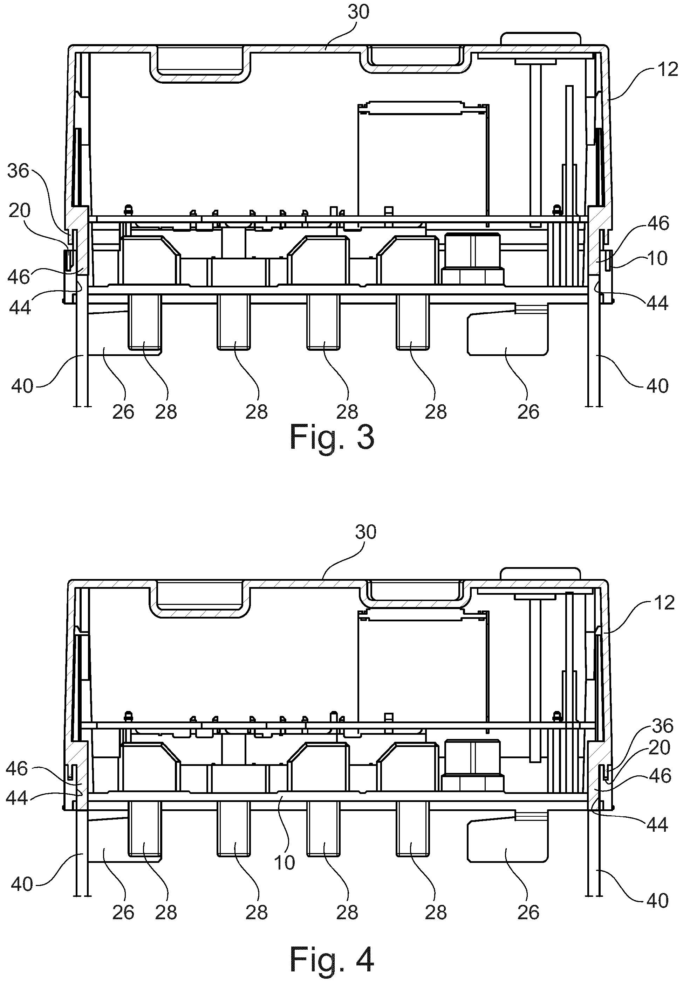

Fig. 3 zeigt die Anordnung aus Fig. 2, nachdem Gehäuseunterteil 10 und Gehäuseoberteil 12 soweit entlang der Schließrichtung zusammengeführt worden sind, dass die Zapfen 46 ein Stück weit in die Durchgangsöffnungen 44 eingreifen, so dass sie eine Führung für die weitere Schließbewegung bilden. In dieser Stellung liegen die freien Enden der Zapfen 46 an den Stirnseiten der Anschlagstifte 40 an und halten das Gehäuseoberteil 12 in einer Vormontagestellung, in der wahlweise z.B. eine Laserbeschriftung an der Vorderseite 30 angebracht werden kann.

In dieser Vormontagestellung sind die Rastnasen 36 noch nicht mit den Rastöffnungen 24 verrastet (in der Schnittebene nicht erkennbar), so dass z.B. bei einer nicht einwandfreien Beschriftung das Gehäuseoberteil 12 einfach entfernt und ausgetauscht werden kann. Anderenfalls kann das Gehäuseoberteil 12 weiter an das Gehäuseunterteil 10 angenähert werden, bis sich die in der Fig. 4 gezeigte, geschlossene Stellung ergibt. Hierzu können die Anschlagstifte 40 entsprechend zurückgezogen werden.

Man erkennt in der Fig. 4, dass der Steg 36 in die Nut 20 eingreift und dass die Zapfen 46 nunmehr in den Durchgangsöffnungen 44 angeordnet sind und diese verschließen. Außerdem sind die Rastnasen 36 jetzt in die Rastöffnungen 24 eingerastet (nicht erkennbar).

Um die ordnungsgemäße Verrastung zu überprüfen, wird das Gehäuseunterteil 10 fixiert und die an den Zapfen 46 anliegenden Anschlagstifte 40 werden einzeln unter Ausführung einer Kraft-Weg-Messung nach oben bewegt. Ein sprunghafter Anstieg der Kraft zeigt die Wirksamkeit der Rastverbindung an, die benachbart zu der jeweiligen Kombination aus Durchgangsöffnung 44 und Zapfen 46 angeordnet ist.

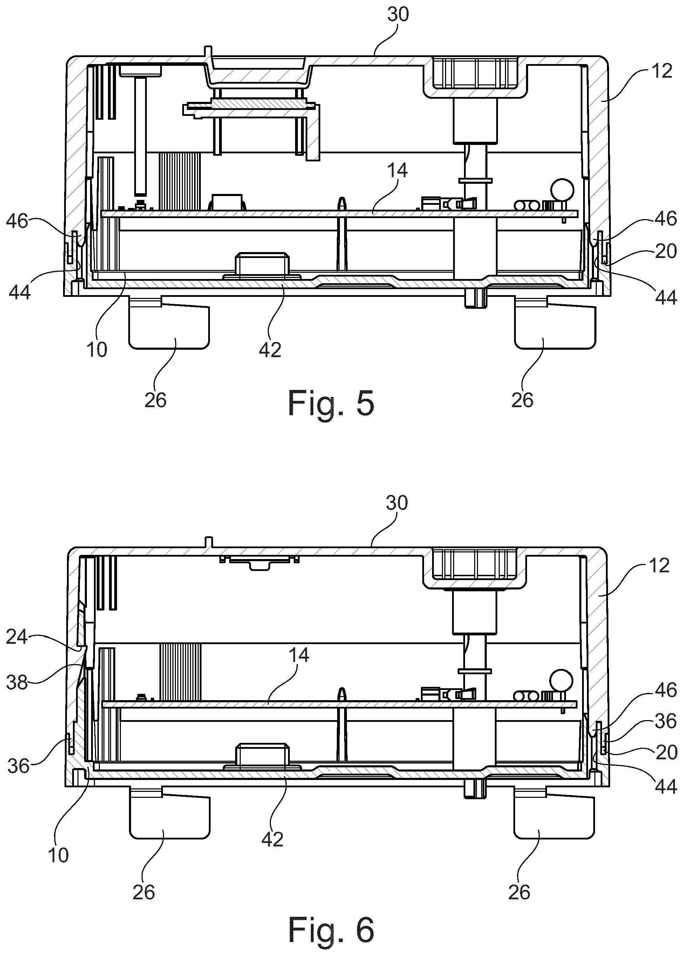

Die Fign. 5 bis 7 zeigen ein weiteres Ausführungsbeispiel, dessen Elemente mit denselben Bezugszeichen versehen sind. Alle drei Figuren zeigen einen Elektrizitätszähler mit geschlossenem Gehäuse. Die Erläuterungen zum ersten Ausführungsbeispiel gelten entsprechend.

Bei der in Fig. 5 gezeigten Schnittführung erkennt man einen wichtigen Unterschied zu dem ersten Ausführungsbeispiel, nämlich dass die Durchgangsöffnungen 44 eine größere Länge aufweisen als die Zapfen 46. In der geschlossenen Stellung ist der Zapfen 46 in der Durchgangsöffnung 44 angeordnet, ein Längsabschnitt der Durchgangsöffnungen 44 bleibt jedoch frei, so dass bei geschlossenem Gehäuse ein Anschlagstift 40 (nicht gezeigt) eingesetzt werden kann, bis er an dem freien Ende des Zapfens 46 anliegt.

Figur 6 zeigt links eine verrastete Stellung von erstem und zweitem Rastelement, d.h. die Rastnase 38 ist in die zugehörige Rastöffnung 24 eingerastet.

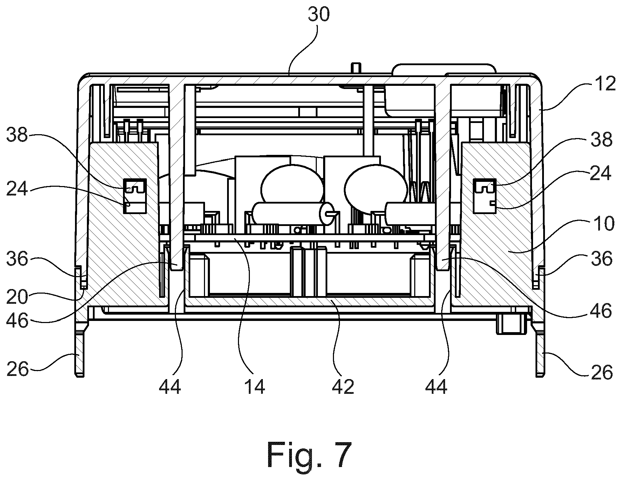

Figur 7 verdeutlicht in einer senkrecht zu der Schnittebene der Fig. 5 angeordneten Schnittebene die Anordnung der Durchgangsöffnungen 44 und Zapfen 46. Sie sind beide nahe des Rands des jeweiligen Gehäuseteils 10, 12 und in einem Abstand von einer Ecke angeordnet. Seitlich benachbart erkennt man jeweils eine Rastverbindung mit Rastnase 38 und Rastöffnung 24.

### Liste der Bezugszeichen

- 10: Gehäuseunterteil
- 12: Gehäuseoberteil
- 14: Leiterplatte
- 16: Anzeige
- 18: Rand (des Gehäuseunterteils)
- 20: Nut
- 22: Arm
- 24: Rastöffnung
- 26: Befestigungslasche
- 28: Steckkontakt
- 30: Vorderseite
- 32: Fenster
- 34: Rand (des Gehäuseoberteils)
- 36: Steg
- 38: Rastnase
- 40: Anschlagstift
- 42: Rückwand
- 44: Durchgangsöffnung

## Patentansprüche

1. Gehäuse für einen Elektrizitätszähler mit einem Gehäuseunterteil (10), das ein erstes Rastelement aufweist, und einem Gehäuseoberteil (12), das ein zweites Rastelement aufweist, wobei das Gehäuseoberteil (12) eine Vorderseite (30) und das Gehäuseunterteil (10) eine Rückwand (42) aufweist und bei an einer Wand befestigten Anordnung des Elektrizitätszählers die Vorderseite (30) einer Bedienperson und die Rückwand (42) der Wand zugewandt ist, wobei das Gehäuse dazu ausgebildet ist, durch Zusammenführen von Gehäuseoberteil (12) und Gehäuseunterteil (10) entlang einer Schließrichtung geschlossen zu werden, und wobei das erste Rastelement und das zweite Rastelement bei geschlossenem Gehäuse miteinander verrastet sind, **dadurch gekennzeichnet, dass** das Gehäuseunterteil (10) eine Durchgangsöffnung (44) und das Gehäuseoberteil (12) einen Zapfen (46) aufweist, der bei geschlossenem Gehäuse in der Durchgangsöffnung (44) angeordnet und von einer Außenseite des Gehäuseunterteils (10) aus durch die Durchgangsöffnung (44) hindurch zugänglich ist.

2. Gehäuse nach Anspruch 1, **dadurch gekennzeichnet, dass** bei geschlossenem Gehäuse ein Längsabschnitt der Durchgangsöffnung (44) frei von dem Zapfen (46) und von einer Außenseite des Gehäuseunterteils (10) aus zugänglich ist.

3. Gehäuse nach Anspruch 1 oder 2, **dadurch gekennzeichnet, dass** das Gehäuse Führungsmittel aufweist, die während des Zusammenführens von Gehäuseoberteil (12) und Gehäuseunterteil (10) eine Führung des Gehäuseoberteils (12) relativ zu dem Gehäuseunterteil (10) bewirken, so dass die Bewegung des Gehäuseoberteils (12) relativ zu dem Gehäuseunterteil (10) spätestens beim Erreichen eines Vormontageabstands im Wesentlichen auf die Schließrichtung beschränkt ist, wobei bei Erreichen des Vormontageabstands das erste Rastelement und das zweite Rastelement noch nicht miteinander verrastet sind.

4. Gehäuse nach Anspruch 3, **dadurch gekennzeichnet, dass** die Führungsmittel von dem Zapfen (46) und der Durchgangsöffnung (44) gebildet sind.

5. Gehäuse nach einem der Ansprüche 1 bis 4, **dadurch gekennzeichnet, dass** der Zapfen (46) bei geschlossenem Gehäuse über eine vorgegebene Länge in der Durchgangsöffnung (44) angeordnet ist, wobei die vorgegebene Länge größer ist als der Vormontageabstand.

6. Gehäuse nach einem der Ansprüche 1 bis 5, **dadurch gekennzeichnet, dass** an dem Gehäuseoberteil (12) und/oder an dem Gehäuseunterteil (10) Blockiermittel angeordnet sind, die ausgehend von einem Vormontageabstand ein weiteres Zusammenführen des Gehäuseoberteils (12) und des Gehäuseunterteils (10) blockieren.

7. Gehäuse nach Anspruch 6, **dadurch gekennzeichnet, dass** die Blockiermittel eine in der Durchgangsöffnung (44) angeordnete Barriere aufweisen.

8. Gehäuse nach Anspruch 6 oder 7, **dadurch gekennzeichnet, dass** die Blockiermittel eine Querschnittsvergrößerung des Zapfens (46) aufweisen.

9. Gehäuse nach einem der Ansprüche 1 bis 8, **dadurch gekennzeichnet, dass** das Gehäuseunterteil (10) mehrere erste Rastelemente und eine entsprechende Anzahl an Durchgangsöffnungen (44) und das Gehäuseoberteil (12) mehrere zweite Rastelemente und eine entsprechende Anzahl an Zapfen (46) aufweist, wobei jedes Paar von Rastelementen eine Rastverbindung bildet und bei geschlossenem Gehäuse jeder Rastverbindung eine Durchgangsöffnung (44) mit einem darin angeordneten Zapfen (46) zugeordnet ist.

10. Verfahren zur Montage eines Elektrizitätszählers, wobei der Elektrizitätszähler ein Gehäuseoberteil (12) und ein Gehäuseunterteil (10) aufweist, wobei das Gehäuseoberteil (12) eine Vorderseite (30) und das Gehäuseunterteil (10) eine Rückwand (42) aufweist und bei an einer Wand befestigten Anordnung des Elektrizitätszählers die Vorderseite (30) einer Bedienperson und die Rückwand (42) der Wand zugewandt ist, wobei das Verfahren die folgenden Schritte umfasst:
• Anordnen des Gehäuseunterteils (10), das ein erstes Rastelement und eine Durchgangsöffnung (44) aufweist, in einer Montageposition,
• Anordnen des Gehäuseoberteils (12), das ein zweites Rastelement und einen Zapfen (46) aufweist, in einem Abstand von dem Gehäuseunterteil (10),
• Zusammenführen des Gehäuseoberteils (12) und des Gehäuseunterteils (10) in einer Schließrichtung, bis das Gehäuse geschlossen ist, das erste Rastelement und das zweite Rastelement miteinander verrastet sind und der Zapfen (46) in der Durchgangsöffnung (44) angeordnet und von einer Außenseite des Gehäuseunterteils (10) aus durch die Durchgangsöffnung (44) hindurch zugänglich ist.

11. Verfahren nach Anspruch 10, **gekennzeichnet durch** den weiteren Schritt:
• Überprüfen, ob das erste Rastelement und das zweite Rastelement miteinander verrastet sind, indem das Gehäuseunterteil (10) fixiert und ein Anschlagelement eines Montagewerkzeugs unter Ausführung einer Kraft-Weg-Messung gegen den Zapfen (46) bewegt wird.

12. Verfahren nach Anspruch 10 oder 11, **dadurch gekennzeichnet, dass** vor dem Zusammenführen von Gehäuseunterteil (10) und Gehäuseoberteil (12) die folgenden Schritte ausgeführt werden:
• das Gehäuseoberteil (12) wird in einem Vormontageabstand von dem Gehäuseunterteil (10) angeordnet, so dass der Zapfen (46) in die Durchgangsöffnung (44) hineinragt, wobei das erste Rastelement und das zweite Rastelement nicht miteinander verrastet sind,
• Positionieren eines Anschlagelements eines Montagewerkzeugs im Bereich der Durchgangsöffnung (44), so dass das Anschlagelement an dem Zapfen (46) anliegt und sich das Gehäuseoberteil (12) in einer vorgegebenen Beschriftungsposition befindet,
• Ausführen einer Beschriftung des Gehäuseoberteils (12).

13. Verfahren nach einem der Ansprüche 10 bis 12, **dadurch gekennzeichnet, dass** nach dem Zusammenführen von Gehäuseoberteil (12) und Gehäuseunterteil (10) der folgende, weitere Schritt ausgeführt wird:
• Überprüfen, ob das erste Rastelement und das zweite Rastelement miteinander verrastet sind, indem das Gehäuseunterteil (10) fixiert und ein Anschlagelement eines Montagewerkzeugs unter Ausführung einer Kraft-Weg-Messung gegen den Zapfen (46) bewegt wird.

14. Verfahren nach einem der Ansprüche 10 bis 13, **dadurch gekennzeichnet, dass** das Gehäuse nach einem der der Ansprüche 1 bis 9 ausgebildet ist.

## Claims

1. A casing for an electricity meter with a casing lower part (10) which has a first latching element and a casing upper part (12) which has a second latching element, wherein the casing upper part (12) has a front face (30) and the casing lower part (10) has a rear wall (42) and, in an arrangement of the electricity meter fastened to a wall, the front face (30) faces an operator and the rear wall (42) faces the wall, wherein the casing is configured to be closed by bringing together the casing upper part (12) and casing lower part (10) along a closing direction, and wherein the first latching element and the second latching element are latched together when the casing is closed, **characterized in that** the casing lower part (10) has a through-opening (44) and the casing upper part (12) has a pin (46) which, when the casing is closed, is arranged in the through-opening (44) and is accessible from an outer face of the casing lower part (10) through the through-opening (44).

2. The casing according to Claim 1, **characterized in that**, when the casing is closed, a longitudinal portion of the through-opening (44) is freely accessible from the pin (46) and from an outer face of the casing lower part (10).

3. The casing according to Claim 1 or 2, **characterized in that** the casing has guide means which bring about a guidance of the casing upper part (12) relative to the casing lower part (10) when the casing upper part (12) and casing lower part (10) are brought together, such that the movement of the casing upper part (12) relative to the casing lower part (10) is substantially restricted to the closing direction at the latest when a pre-assembly distance is reached, wherein the first latching element and the second latching element are not yet latched together when the pre-assembly distance is reached.

4. The casing according to Claim 3, **characterized in that** the guide means are formed by the pin (46) and the through-opening (44).

5. The casing according to one of Claims 1 to 4, **characterized in that**, when the casing is closed, the pin (46) is arranged over a predetermined length in the through-opening (44), wherein the predetermined length is greater than the pre-assembly distance.

6. The casing according to one of Claims 1 to 5, **characterized in that** blocking means are arranged on the casing upper part (12) and/or on the casing lower part (10), which blocking means, starting from a pre-assembly distance, block a further bringing together of the casing upper part (12) and the casing lower part (10).

7. The casing according to Claim 6, **characterized in that** the blocking means have a barrier arranged in the through-opening (44).

8. The casing according to Claim 6 or 7, **characterized in that** the blocking means have a cross-sectional enlargement of the pin (46).

9. The casing according to one of Claims 1 to 8, **characterized in that** the casing lower part (10) has a plurality of first latching elements and a corresponding number of through-openings (44) and the casing upper part (12) has a plurality of second latching elements and a corresponding number of pins (46), wherein each pair of latching elements forms a latching connection and, when the casing is closed, each latching connection is assigned a through-opening (44) with a pin (46) arranged therein.

10. A method for the assembly of an electricity meter, wherein the electricity meter has a casing upper part (12) and a casing lower part (10), wherein the casing upper part (12) has a front face (30) and the casing lower part (10) has a rear wall (42) and, in an arrangement of the electricity meter fastened to a wall, the front face (30) faces an operator and the rear wall (42) faces the wall, wherein the method comprises the following steps:
• arranging the casing lower part (10), which has a first latching element and a through-opening (44), in an assembly position,
• arranging the casing upper part (12), which has a second latching element and a pin (46), at a distance from the casing lower part (10),
• bringing together the casing upper part (12) and the casing lower part (10) in a closing direction until the casing is closed, the first latching element and the second latching element being latched together and the pin (46) being arranged in the through-opening (44) and being accessible from an outer face of the casing lower part (10) through the through-opening (44).

11. The method according to Claim 10, **characterized by** the further step:
• verifying whether the first latching element and the second latching element are latched together, by the casing lower part (10) being fixed and a stop element of an assembly tool being moved toward the pin (46), carrying out a force-displacement measurement.

12. The method according to Claim 10 or 11, **characterized in that** before the casing lower part (10) and casing upper part (12) are brought together the following steps are carried out:
• the casing upper part (12) is arranged at a pre-assembly distance from the casing lower part (10) so that the pin (46) protrudes into the through-opening (44), wherein the first latching element and the second latching element are not latched together,
• positioning a stop element of an assembly tool in the region of the through-opening (44) so that the stop element bears against the pin (46) and the casing upper part (12) is in a predetermined inscription position,
• carrying out an inscription of the casing upper part (12).

13. The method according to one of Claims 10 to 12, **characterized in that** after the casing upper part (12) and casing lower part (10) have been brought together the following further step is carried out:
• verifying whether the first latching element and the second latching element are latched together, by the casing lower part (10) being fixed and a stop element of an assembly tool being moved toward the pin (46), carrying out a force-displacement measurement.

14. The method according to one of Claims 10 to 13, **characterized in that** the casing is configured according to one of Claims 1 to 9.

## Revendications

1. Boîtier pour un compteur d'électricité comprenant une partie inférieure de boîtier (10) dotée d'un premier élément d'encliquetage, et une partie supérieure de boîtier (12) dotée d'un deuxième élément d'encliquetage, dans lequel la partie supérieure de boîtier (12) présente un côté avant (30) et la partie inférieure de boîtier (10) présente une paroi arrière (42) et, lorsque le compteur d'électricité est agencé de manière à être fixé à un mur, le côté avant (30) est tourné vers un opérateur et la paroi arrière (42) vers le mur, dans lequel le boîtier est conçu pour être fermé en rapprochant la partie supérieure de boîtier (12) et la partie inférieure de boîtier (10) le long d'une direction de fermeture, et dans lequel le premier élément d'encliquetage et le deuxième élément d'encliquetage sont encliquetés l'un avec l'autre lorsque le boîtier est fermé, **caractérisé en ce que** la partie inférieure de boîtier (10) présente une ouverture de passage (44) et la partie supérieure de boîtier (12) présente un tenon (46), lequel est agencé dans l'ouverture de passage (44) lorsque le boîtier est fermé et accessible à travers l'ouverture de passage (44) depuis un côté extérieur de la partie inférieure de boîtier (10).

2. Boîtier selon la revendication 1, **caractérisé en ce que** lorsque le boîtier est fermé, une section longitudinale de l'ouverture de passage (44) est libre du tenon (46) et accessible depuis un côté extérieur de la partie inférieure de boîtier (10).

3. Boîtier selon la revendication 1 ou 2, **caractérisé en ce que** le boîtier présente des moyens de guidage, lesquels entraînent un guidage de la partie supérieure de boîtier (12) par rapport à la partie inférieure de boîtier (10) pendant le rapprochement de la partie supérieure de boîtier (12) et de la partie inférieure de boîtier (10), de telle façon que le déplacement de la partie supérieure de boîtier (12) par rapport à la partie inférieure de boîtier (10) est limité essentiellement à la direction de fermeture au plus tard lorsqu'une distance de prémontage est atteinte, dans lequel, lorsque la distance de prémontage est atteinte, le premier élément d'encliquetage et le deuxième élément d'encliquetage ne sont pas encore encliquetés l'un avec l'autre.

4. Boîtier selon la revendication 3, **caractérisé en ce que** les moyens de guidage sont formés par le tenon (46) et l'ouverture de passage (44).

5. Boîtier selon l'une des revendications 1 à 4, **caractérisé en ce que** le tenon (46) est agencé dans l'ouverture de passage (44) sur une longueur prédéfinie lorsque le boîtier est fermé, dans lequel la longueur prédéfinie est supérieure à la distance de prémontage.

6. Boîtier selon l'une des revendications 1 à 5, **caractérisé en ce que** des moyens de blocage sont agencés sur la partie supérieure de boîtier (12) et/ou sur la partie inférieure de boîtier (10), lesquels bloquent un rapprochement supplémentaire de la partie supérieure de boîtier (12) et de la partie inférieure de boîtier (10) à partir d'une distance de prémontage.

7. Boîtier selon la revendication 6, **caractérisé en ce que** les moyens de blocage présentent une barrière agencée dans l'ouverture de passage (44).

8. Boîtier selon la revendication 6 ou 7, **caractérisé en ce que** les moyens de blocage présentent un agrandissement de section transversale du tenon (46).

9. Boîtier selon l'une des revendications 1 à 8, **caractérisé en ce que** la partie inférieure de boîtier (10) présente plusieurs premiers éléments d'encliquetage et un nombre correspondant d'ouvertures de passage (44) et la partie supérieure de boîtier (12) présente plusieurs deuxièmes éléments d'encliquetage et un nombre correspondant de tenons (46), dans lequel chaque paire d'éléments d'encliquetage forme une liaison par encliquetage et lorsque le boîtier est fermé, une ouverture de passage (44) avec un tenon (46) agencé dans celle-ci est associée à chaque liaison par encliquetage.

10. Procédé de montage d'un compteur d'électricité, dans lequel le compteur d'électricité présente une partie supérieure de boîtier (12) et une partie inférieure de boîtier (10), dans lequel la partie supérieure de boîtier (12) présente un côté avant (30) et la partie inférieure de boîtier (10) présente une paroi arrière (42) et, lorsque le compteur d'électricité est agencé de manière à être fixé à un mur, le côté avant (30) est tourné vers un opérateur et la paroi arrière (42) vers le mur, dans lequel le procédé comporte les étapes suivantes :
• agencement de la partie inférieure de boîtier (10), laquelle présente un premier élément d'encliquetage et une ouverture de passage (44), dans une position de montage,
• agencement de la partie supérieure de boîtier (12), laquelle présente un deuxième élément d'encliquetage et un tenon (46), à une distance de la partie inférieure de boîtier (10),
• rapprochement de la partie supérieure de boîtier (12) et de la partie inférieure de boîtier (10) dans une direction de fermeture jusqu'à ce que le boîtier soit fermé, le premier élément d'encliquetage et le deuxième élément d'encliquetage soient encliquetés l'un avec l'autre et le tenon (46) soit agencé dans l'ouverture de passage (44) et accessible à travers l'ouverture de passage (44) depuis un côté extérieur de la partie inférieure de boîtier (10).

11. Procédé selon la revendication 10, **caractérisé par** l'étape supplémentaire suivante :
• vérification si le premier élément d'encliquetage et le deuxième élément d'encliquetage sont encliquetés l'un avec l'autre, par fixation de la partie inférieure de boîtier (10) et déplacement d'un élément de butée d'un outil de montage contre le tenon (46) en exécutant une mesure de force-distance.

12. Procédé selon la revendication 10 ou 11, **caractérisé en ce qu'**avant le rapprochement de la partie inférieure de boîtier (10) et de la partie supérieure de boîtier (12), les étapes suivantes sont exécutées :
• la partie supérieure de boîtier (12) est agencée à une distance de prémontage par rapport à la partie inférieure de boîtier (10), de telle façon que le tenon (46) fait saillie dans l'ouverture de passage (44), le premier élément d'encliquetage et le deuxième élément d'encliquetage n'étant pas encliquetés l'un avec l'autre,
• positionnement d'un élément de butée d'un outil de montage dans la région de l'ouverture de passage (44), de telle façon que l'élément de butée s'applique sur le tenon (46) et la partie supérieure de boîtier (12) se trouve dans une position d'étiquetage prédéfinie,
• exécution d'un étiquetage de la partie supérieure de boîtier (12).

13. Procédé selon l'une des revendications 10 à 12, **caractérisé en ce qu'**après le rapprochement de la partie supérieure de boîtier (12) et de la partie inférieure de boîtier (10), l'étape suivante supplémentaire est exécutée :
• vérification si le premier élément d'encliquetage et le deuxième élément d'encliquetage sont encliquetés l'un avec l'autre, par fixation de la partie inférieure de boîtier (10) et déplacement d'un élément de butée d'un outil de montage contre le tenon (46) en exécutant une mesure de force-distance.

14. Procédé selon l'une des revendications 10 à 13, **caractérisé en ce que** le boîtier est réalisé selon l'une des revendications 1 à 9.
